# DEMANDE DE BREVET EUROPEEN

(11) **EP 0 642 163 A1**
(43) Date de publication de la demande: **08.03.1995**
(21) Numéro de dépôt: 94401964.5
(22) Date de dépôt: 05.09.1994
(51) Int. Cl.: H01L 25/065

(54) **Procédé d'assemblage tridimensionnel de composants électroniques par boucles de microfils et éléments de soudure**

(30) Priorité: 06.09.1993 FR 9310557
(71) Demandeur: COMMISSARIAT A L'ENERGIE ATOMIQUE, F-75015 Paris (FR)
(72) Inventeur: Marion, François, F-38120 Saint Egereve (FR); Pornin, Jean-Louis, 38920 Crolles (FR); Imperinetti, Pierre, F-38180 Seyssins (FR)
(74) Mandataire: Dubois-Chabert, Guy

(57) **Abrégé**

Selon l'invention, pour assembler au moins un premier composant électronique (1) muni d'au moins un premier plot de contact électrique (5) et au moins un second composant électronique (10) muni d'au moins un second plot de contact électrique (13), on réalise une boucle de microfil conducteur (7) ayant au moins une extrémité sur le premier plot, on réalise un élément de soudure sur le second plot, on positionne les composants de façon que la boucle soit en regard de l'élément de soudure, on chauffe l'ensemble pour fondre l'élément de soudure (15b) et assurer la fixation de la boucle sur celui-ci, et on refroidit l'ensemble.

## Description

L'invention a pour objet un procédé d'assemblage de composants électroniques, faisant intervenir des interconnexions tridimensionnelles.

Ces composants électroniques peuvent être des puces de circuits intégrés ainsi que des substrats d'interconnexion équipés d'une ou plusieurs couches de conducteurs électriques.

L'invention trouve une application dans les domaines de la microélectronique, de l'informatique, de l'optoélectronique et du traitement de signal.

Elle permet en particulier la fabrication, à faible coût, d'ensembles ("racks") de mémoires appelés "stacked memories" dans les articles en langue anglaise.

On cherche de plus en plus à miniaturiser les systèmes électroniques ou informatiques utilisant des circuits intégrés.

Or, l'un des facteurs limitatifs de la taille de ces systèmes est aujourd'hui l'assemblage des puces et des circuits intégrés ainsi que leur interconnexion.

Dans le but de réaliser des circuits complexes denses, plusieurs approches ont été réalisées.

La première approche a été de supprimer les boîtiers électroniques autour des puces et d'hybrider directement les puces avec des billes de soudure sur des substrats multicouches réalisant les interconnexions entre les puces.

Cette première technique dite "flip-chip" conduit à l'hybridation de centaines de puces sur des substrats en céramique (technique "multi-chip module").

Elle est décrite par exemple dans le brevet IBM US-A-4 202 007 et dans le document FR-A-2 611 986 (Thomson Semiconducteurs).

Cette technique permet d'occuper une surface d'interconnexion au minimum égale à la somme totale des surfaces des puces hybridées, puisqu'elles se trouvent toutes dans un même plan.

Une deuxième technique dite "tridimensionnelle" permet de ramener les interconnexions dans un volume réduit par rapport à celui de la première technique.

Cette deuxième technique consiste à coller les puces les unes sur les autres et à réaliser une technologie sur la tranche du bloc ainsi obtenu de manière à interconnecter les puces entre elles par leur tranche.

Cette deuxième technique est relativement complexe et coûteuse à mettre en oeuvre, ce qui fait qu'elle n'est pas utilisée actuellement en fabrication.

Elle est en particulier décrite dans la publication IEEE transactions on CHMT, Dec. 90, vol. 13, N°4, pp. 814-821 de C. Val et T. Lemoine, "3-D Interconnection for ultra-dense multichip".

Par ailleurs, en vue de réduire la longueur des fils de liaison entre les circuits intégrés ou les puces et donc de limiter les capacités de lignes d'interconnexion qui sont des facteurs limitatifs des vitesses de commutation des assemblages actuels, on a envisagé de recouvrir l'emplacement de réception des puces, dans un boîtier céramique multicouche, de nombreux plots conducteurs isolés les uns des autres et pouvant servir de relais de soudure pour des fils de liaison plus courts.

Cet assemblage est notamment décrit dans le document FR-A-2 647 962.

Cette dernière technique utilise des boîtiers électroniques autour des puces et ne conduit donc pas à une miniaturisation suffisante de l'assemblage.

La présente invention a justement pour objet un procédé d'assemblage tridimensionnel de composants électroniques par boucles de microfils et éléments de soudure ("solder elements" dans les publications en langue anglaise) permettant de remédier aux différents inconvénients mentionnés ci-dessus.

Ces composants électroniques peuvent être des puces d'un ou plusieurs circuits intégrés ou des substrats d'interconnexion.

L'invention permet en particulier la réalisation d'un assemblage de puces de circuits intégrés dans un volume réduit, sur une surface largement inférieure à celle utilisée dans la première technique citée ci-dessus.

Elle permet également la réalisation séparément d'un substrat d'interconnexion testable complexe multicouche, destiné à relier des puces entre elles, ce que ne permet pas la deuxième technique exposée où les interconnexions sont réalisées après assemblage des puces.

Elle permet en outre de réduire les longueurs des lignes d'interconnexions entre les puces et de limiter ainsi les capacités de ces lignes d'interconnexions.

De façon plus précise, l'invention a pour objet un procédé d'assemblage d'au moins un premier composant électronique, muni sur une de ses faces d'au moins un premier plot ("pad" dans les publications en langue anglaise) de contact électrique, et d'au moins un second composant électronique muni sur une de ses faces d'au moins un second plot de contact électrique destiné à être connecté au premier plot de contact, caractérisé en ce qu'il comprend les étapes suivantes :
a) - réalisation d'une boucle de microfil conducteur ayant au moins une extrémité sur le premier plot de contact et étant orientée perpendiculairement à ladite face du premier composant ;
b) - réalisation d'un élément de soudure sur le second plot de contact, cet élément étant constitué d'un matériau conducteur dont le point de fusion est inférieur à ceux des premier et second plots et à celui de la boucle de microfil, ce matériau étant apte à mouiller le second plot et la boucle de microfil ;
c) - positionnement des premier et second composants électroniques perpendiculairement entre eux et au contact l'un de l'autre par la tranche, de façon que la boucle de microfil soit en regard de l'élément de soudure ;
d) - chauffage de l'ensemble pour fondre l'élément de soudure et assurer la fixation de la boucle de microfil sur l'élément de soudure,
e) - refroidissement de l'ensemble à une température inférieure à la température de fusion de l'élément de soudure.

Un tel procédé est beaucoup plus simple et moins coûteux à mettre en oeuvre qu'un procédé qui utiliserait des microfils conducteurs rectilignes, perpendiculaires à la face du premier composant.

En effet, il faudrait fabriquer de tels microfils rectilignes par croissance électrolytique d'un matériau conducteur à travers des ouvertures pratiquées dans une résine photosensible, ce qui impliquerait la mise en oeuvre de techniques photolithographiques et donc l'utilisation de salles blanches et d'équipements onéreux.

Au contraire, l'étape a) du procédé objet de l'invention est réalisable de façon simple, par soudure du microfil conducteur sur le premier plot de contact.

Dans la présente invention, on utilise un ou plusieurs premiers composants électroniques comportant chacun un ou plusieurs premiers plots conducteurs pourvus chacun d'un microfil et destinés à être connectés.

De même, on utilise un ou plusieurs seconds composants électroniques comportant chacun un ou plusieurs seconds plots conducteurs.

Les premiers et seconds composants électroniques sont disposés à 90° l'un de l'autre, limitant ainsi la surface occupée par l'assemblage à former.

Avantageusement, chaque microfil peut avoir un diamètre allant de 15 à 50µm et chaque boucle de microfil peut avoir une hauteur de 30 à 200µm.

Lorsque l'un des premier et second composants électroniques comporte n premiers plots conducteurs situés avantageusement sur un seul côté d'une même face du composant sur laquelle ils sont montés, avec n entier ≧2, l'autre composant comporte n seconds plots disposés sur une même rangée et connectés respectivement aux n premiers plots.

En vue d'une miniaturisation optimum, le centre du ou des seconds plots conducteurs du second composant électronique est situé à une distance d d'un bord de ladite face du second composant telle que d<L+( (φ/2), avec L représentant la hauteur de la boucle de microfil et φ représentant le diamètre de l'élément de soudure après fusion puis refroidissement de celui-ci.

Lorsqu'on utilise deux seconds composants électroniques ou plus, équipés chacun de plusieurs seconds plots conducteurs, ces seconds composants électroniques sont par exemple orientés parallèlement entre eux et perpendiculairement à un premier composant électronique, ce dernier comportant au moins deux séries de premiers plots conducteurs équipés de microfils, disposés par exemple selon deux droites parallèles et connectés respectivement aux seconds plots des deux seconds composants électroniques.

Dans ce cas particulier, le premier composant électronique est un substrat d'interconnexion par exemple en céramique du type multicouche et les seconds composants électroniques sont des puces de circuits intégrés.

Ainsi, en disposant les seconds composants électroniques sur leur tranche, on obtient une miniaturisation optimum de l'assemblage à former.

Il est aussi possible, selon l'invention, que le premier composant électronique consiste en une puce de circuit intégré.

Dans ce cas, le second composant électronique peut alors être un substrat d'interconnexion, du type multicouche.

On utilise alors au moins deux premiers composants électroniques parallèles entre eux et connectés perpendiculairement à un second composant électronique.

Selon un mode de mise en oeuvre particulier du procédé objet de l'invention, la boucle de microfil conducteur est réalisée de façon que ses deux extrémités soient sur le premier plot de contact électrique.

Selon un autre mode de mise en oeuvre particulier, le premier composant électronique comprend au moins deux premiers plots de contact électrique et la boucle de microfil conducteur est réalisée de façon que ses deux extrémités soient respectivement sur ces deux premiers plots de contact électrique.

Une fois la boucle de microfil réalisée, on peut couper un brin de celle-ci.

De façon avantageuse, l'étape b) du procédé objet de l'invention peut consister à former sur chaque second plot conducteur une galette plate en matériau de soudure conducteur dont la surface est supérieure à celle du second plot.

Dans l'étape (d), lorsque ces galettes sont chauffées au- dessus du point de fusion du matériau de soudure les constituant, les forces de tension superficielle en modifient la forme et elles se mettent sous la forme d'une sphère dont la hauteur est supérieure à celle de la galette avant sa fusion.

Après l'étape (e) et si cela est nécessaire, l'ensemble obtenu peut être rigidifié par un enrobage tel qu'un matériau électriquement isolant de protection utilisé classiquement lors de la mise en boîtier de circuits électroniques.

L'invention a aussi pour objet la fabrication des circuits intégrés permettant la mise en oeuvre du procédé conforme à l'invention.

Ainsi, l'invention a encore pour objet un circuit intégré comportant sur l'une de ses faces plusieurs premiers plots de contact électrique devant être connectés à des seconds plots de contact électrique d'un autre circuit intégré, caractérisé en ce que les premiers plots de contact comportent chacun une boucle de microfil conducteur orientée perpendiculairement à ladite face.

L'invention a encore pour objet un circuit intégré comportant sur une de ses faces plusieurs seconds plots de contact électrique devant être connectés à des premiers plots de contact électrique d'un autre circuit intégré, caractérisé en ce que les seconds plots de contact comportent chacun une galette de soudure dont le point de fusion est inférieur à celui des seconds plots, la galette ayant une surface supérieure à celle de chaque second plot.

D'autres caractéristiques et avantages de l'invention ressortiront mieux de la description qui va suivre, donnée à titre illustratif et non limitatif, en référence aux dessins annexés dans lesquels :
- la figure 1 montre un substrat d'interconnexion destiné à être assemblé selon l'invention et comportant une série de boucles de microfils ;
- la figure 2 montre un circuit intégré destiné à être assemblé sur le substrat d'interconnexion de la figure 1, ce circuit intégré comportant les éléments de soudure destinés à être soudés aux boucles de microfils ;
- la figure 3 montre le détail d'un élément de soudure du circuit intégré de la figure 2, après sa fusion ;
- la figure 4 montre l'assemblage réalisé d'une série de circuits intégrés sur un substrat d'interconnexion, conformément à l'invention ;
- la figure 5 montre le détail de l'assemblage d'une boucle de microfil et d'une galette de soudure, avant la fusion de celle-ci ;
- la figure 6 montre le détail d'une interconnexion à boucle de microfil réalisée selon l'invention ;
- la figure 7 illustre schématiquement la possibilité de couper un brin de chaque boucle de microfil après réalisation de l'assemblage ;
- la figure 8 illustre schématiquement la possibilité de fixer une extrémité de chaque boucle de microfil à un plot et l'autre extrémité de cette boucle à un autre plot ; et
- les figures 9 et 10 illustrent schématiquement un mode de mise en oeuvre particulier du procédé objet de l'invention dans lequel des boucles de microfils se trouvent sur des circuits intégrés tandis que des galettes de soudure sont placées sur un substrat d'interconnexion.

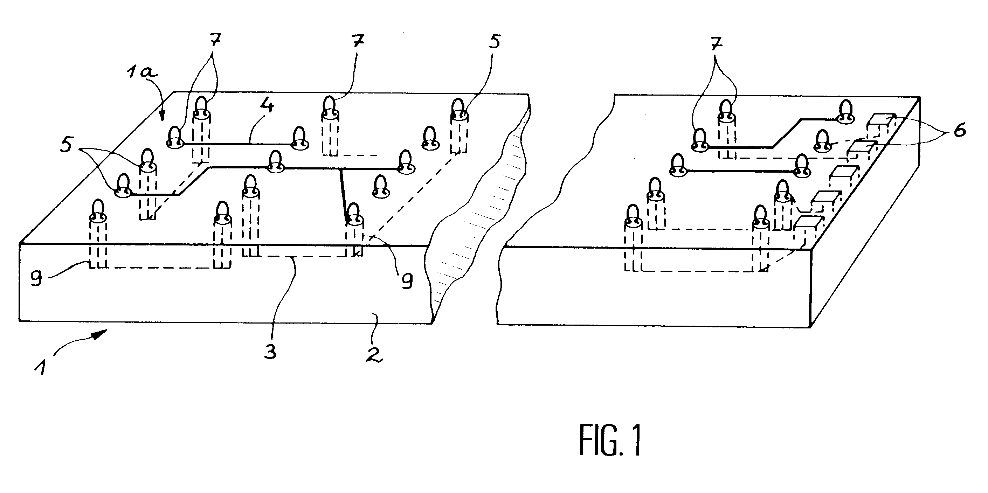

La figure 1 montre une partie d'un substrat d'interconnexion multicouche 1, fabriqué conformément à l'art antérieur.

Ce substrat est constitué d'un substrat isolant 2 en céramique (Al₂O₃, SiO₂, etc.) ou en matière plastique rigide (polyméthacrylate de méthyle par exemple) comportant une ou plusieurs couches telles que 3 et 4 de lignes électriquement conductrices.

Les lignes 3 sont logées dans le substrat et les lignes 4 sont formées en surface du substrat.

Ces lignes conductrices peuvent être reliées électriquement entre elles ou être isolées selon leur besoin et constituent un réseau d'interconnexion.

Un tel substrat est notamment celui décrit dans le brevet d'IBM US-A-4 202 007.

Les sorties électriques de ce substrat multicouche 1 aboutissent à des plots de contact électrique 5 ou 6.

Les plots de contact 5 formés sur l'ensemble de la surface la de grande dimension du substrat 1 sont destinés à la liaison des lignes conductrices 3 et 4 du substrat multicouche et à la connexion d'un point particulier d'un circuit intégré à un point particulier d'un autre circuit intégré.

Les plots de contact 5 sont formés sur des ouvertures 9 pratiquées dans le matériau isolant 2 du substrat.

Ils sont disposés par exemple selon des rangées parallèles entre elles sur la surface 1a.

Les sorties électriques 6 sont destinées à une sortie ou à une entrée d'un signal extérieur au substrat 1.

Elles sont situées à la périphérie de la surface la du substrat.

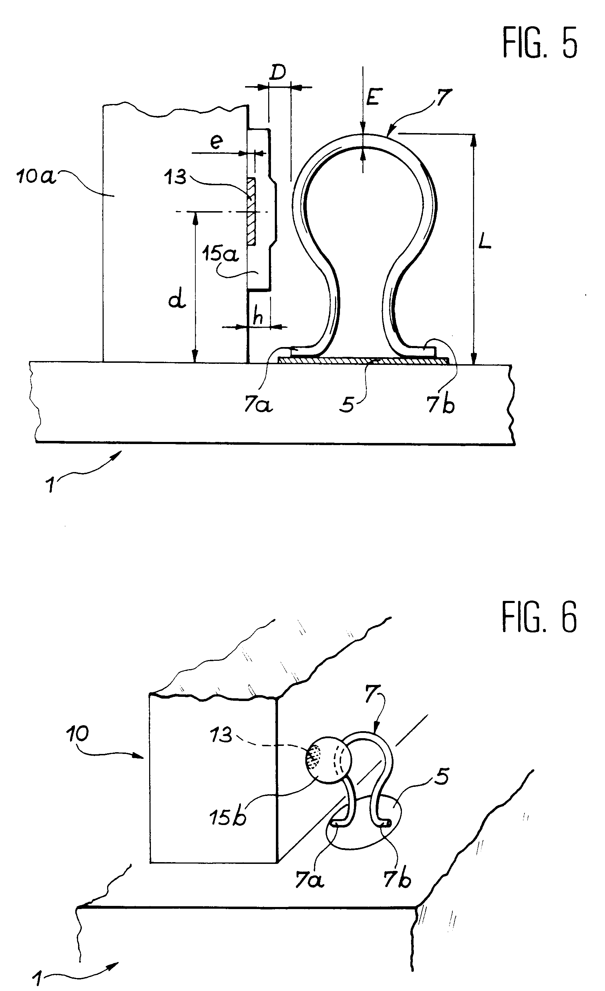

Conformément à l'invention, le substrat 1 comporte sur ses plots de contact électrique 5, destinés à la liaison de lignes conductrices 3 ou 4 du substrat d'interconnexion, des boucles verticales de microfils 7 dont un exemplaire est représenté de façon plus détaillée sur la figure 5.

Chaque boucle de microfil 7 est constituée d'un matériau électriquement conducteur, par exemple l'or ou l'or nickelé.

Elle présente une hauteur L qui peut atteindre de 30 à 200µm pour un diamètre E de microfil de 15 à 50µm.

Ceci permet des connexions à un pas faible.

Typiquement, pour un diamètre E de 15µm, on obtient un pas de 50µm.

Pour former les boucles de microfils 7, le substrat 1 est amené sur une station de soudure par fil, du type "wire-bonding" en utilisant les techniques de "ball-bonding" ou "wedge-bonding".

Chacun des plots destinés à être connecté est alors muni d'un microfil en boucle.

Pour ce faire, on amène le microfil sur le plot, on réalise une soudure de ce microfil sur ce plot, on forme la boucle (la soudure précédemment réalisée correspondant à une extrémité 7a de la boucle), on soude à nouveau le microfil sur le plot, cette nouvelle soudure correspondant à l'autre extrémité 7b de la boucle.

Dans l'exemple représenté sur la figure 5, chaque boucle a sensiblement la forme d'un Ω.

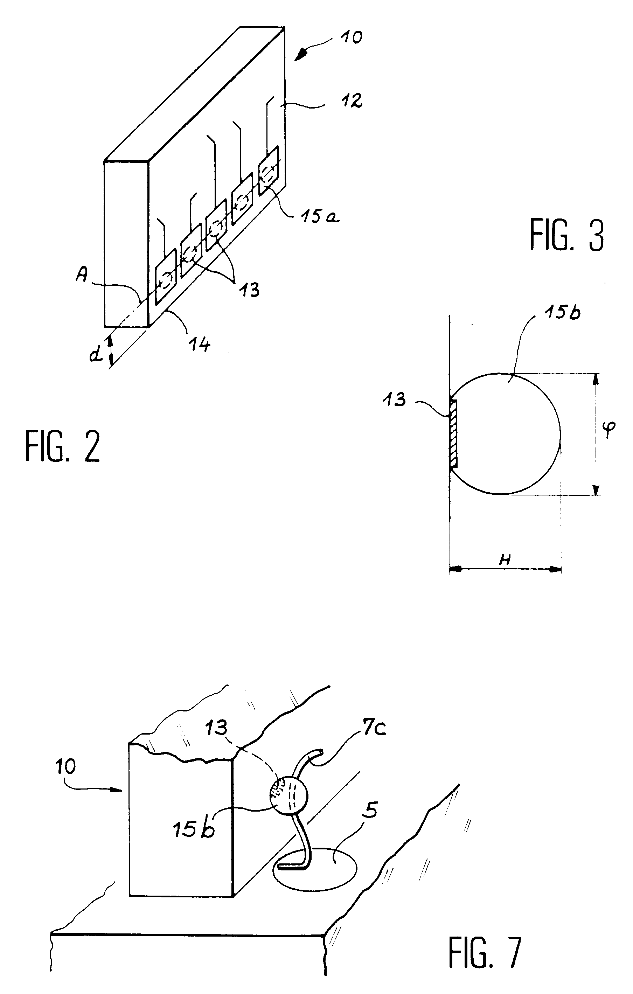

Le substrat d'interconnexion 1 de la figure 1 est destiné à recevoir un ou plusieurs circuits intégrés tels que représentés sur la figure 2.

Ces circuits portent la référence générale 10.

Ils sont réalisés de façon connue et comportent sur l'une de leurs faces de grande dimension 12 des plots de contact électrique 13 destinés à leur interconnexion (voir figure 2).

Le nombre de plots de contact électrique 13 de chaque circuit intégré est par exemple égal à celui des plots de contact 5 d'une même rangée.

Ces plots de contact électrique 13 sont tous disposés sur un même bord de la face 12 du circuit intégré (ici le bord inférieur 14).

Ces plots de contact 13 ont leurs centres disposés approximativement selon une droite A parallèle au bord 14 de la face 12.

La distance séparant la droite A du bord 14 est notée d.

Conformément à l'art antérieur, les plots de contact électrique 13 sont formés dans une couche supérieure d'isolant électrique.

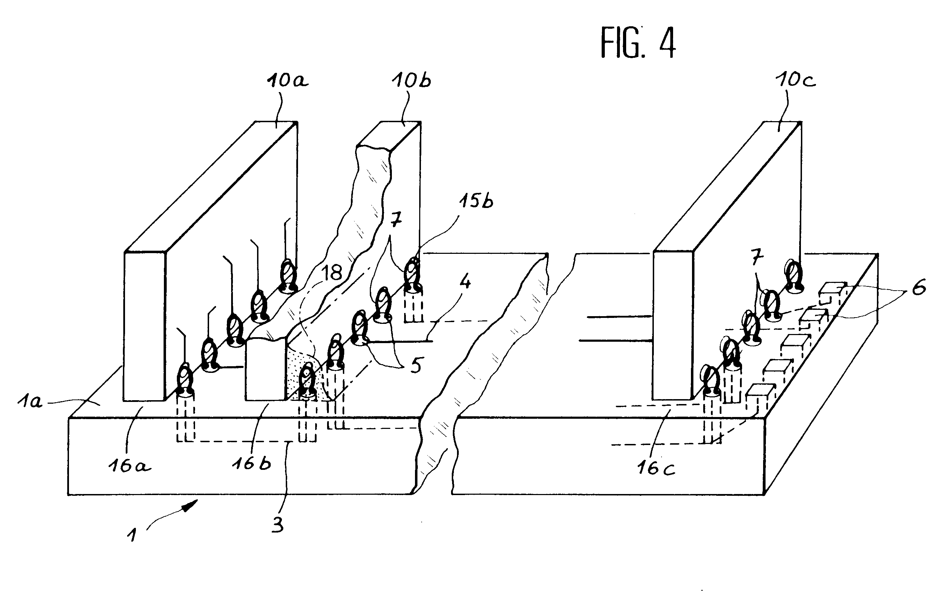

Conformément à l'invention, chaque plot conducteur 13 est destiné à être connecté à un plot conducteur 5, via les boucles de microfils 7 et des éléments de soudure, représentés de façon plus détaillée sur la figure 5, avant leur fusion et sur les figures 3 et 6 après leur fusion.

Les éléments de soudure sont constitués d'un matériau électriquement conducteur dont le point de fusion est inférieur à celui des boucles de microfils 7 ainsi qu'à celui des contacts électriques 13 et 5 à interconnecter.

Ces éléments de soudure sont déposés par une technique dite "lift off" sur les plots 13.

Ils présentent la forme d'une galette 15a avant leur fusion (voir figure 5) dont la surface est supérieure à celle du plot de contact électrique 13.

En pratique, l'épaisseur h d'une galette vaut de 4 à 50µm pour des plots de contact 13 de 0,1 à 5µm d'épaisseur e.

Les éléments de soudure sont par exemple réalisés en étain, en un alliage d'or et d'étain, en alliage d'étain-plomb ou tout autre matériau classique de soudure et les plots de contact électrique 5 et 13 sont par exemple réalisés en or, nickel, platine ou cuivre.

Lorsque les galettes 15a de soudure sont chauffées au- dessus du point de fusion du métal les constituant, les forces de tension superficielle en modifient la forme et elles se mettent, comme représenté sur la figure 3, sous la forme d'une sphéroïde 15b de hauteur H supérieur à h.

Typiquement H varie de 10 à 200µm.

Conformément à l'invention, la distance d entre le centre des plots de contact 13 et le bord inférieur 14 du circuit intégré sur lequel ces plots sont implantés, satisfait à la relation d<L+((φ/2) où L est la hauteur des boucles de microfils 7 et φ est le diamètre des éléments de soudure formant des sphéroïdes 15b.

φ varie typiquement entre 10µm et 200µm.

Le substrat d'interconnexion 1 équipé de ses boucles de microfils 7 et des circuits intégrés 10a, 10b, 10c équipés de leurs éléments de soudure 15a, sous forme de galettes, et réalisés comme sur la figure 2, peuvent alors être connectés, comme représenté sur la figure 4.

Le substrat d'interconnexion 1 est disposé horizontalement dans un appareil équipé de moyens de chauffage tels qu'un four.

Les circuits intégrés, respectivement 10a, 10b, . .., 10c sont disposés verticalement sur les sites de réception 16a, 16b et 16c du substrat d'interconnexion 1 ; ces sites de réception sont équipés chacun d'une rangée de plots de contact 5 muni de leurs boucles de microfils 7.

Ainsi, les différents circuits intégrés 10a-10c sont disposés parallèlement entre eux, leurs faces 12 équipées des plots de contact 13 à connecter étant situées en regard de la face de circuit intégré contiguë, dépourvue des plots de contact.

Les circuits intégrés 10a-10c sont positionnés de façon à reposer sur leur tranche et les galettes 15a sont en regard des boucles de microfils 7, comme représenté de façon plus détaillée sur la figure 5.

Le positionnement des circuits intégrés 10a à 10c sur les sites 16a-16c du substrat 1 est réalisé avec une précision telle que la surface des éléments de soudure 15a en forme de galettes (c'est-à-dire avant soudure) se trouve à une distance D des boucles de microfils 7, qui est inférieure ou égale à H-h.

Cette distance D peut être par exemple de 20µm maximum pour des galettes de soudure 15a d'épaisseur h de 12µm et d'une surface de 1200µm² (soit 30umx40µm).

L'ensemble ainsi réalisé est chauffé à une température supérieure à celle du point de fusion des galettes 15a en atmosphère inerte (azote par exemple) ou en atmosphère réductrice (hydrogène par exemple).

Les galettes 15a prennent alors la forme d'un sphéroïde 15b, comme représenté de façon plus détaillée sur la figure 6 ; ces derniers viennent au contact des microfils 7 et se soudent à ceux-ci.

La température de l'ensemble est ramenée à une température inférieure à la température de fusion du métal de soudure et en particulier à la température ambiante.

Chaque sphéroïde 15b de soudure étant alors connecté à une boucle de microfil 7, il s'ensuit que chaque plot de contact 5 est relié à un plot de contact 13 et par conséquent que les lignes conductrices 3 et 4 du substrat 1 se trouvent connectées avec les éléments de circuit des circuits 10a-10c, par l'intermédiaire du substrat multicouche 1.

L'assemblage final est celui représenté sur la figure 4.

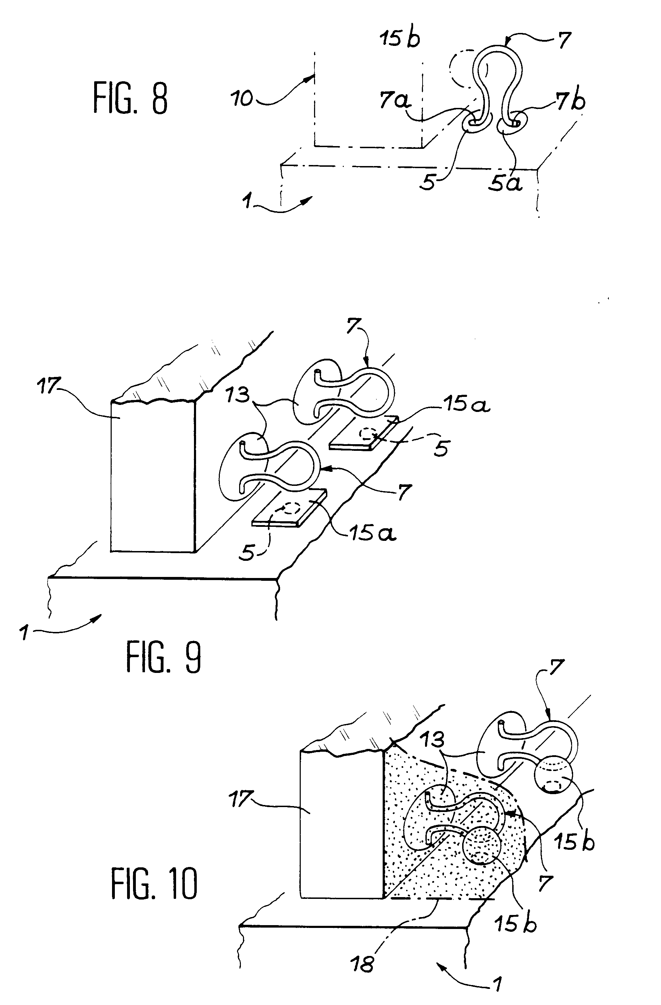

La figure 7 illustre schématiquement la possibilité de couper un brin d'une boucle de microfil une fois celle-ci réalisée : sur la figure 7, on a coupé le brin le plus éloigné du circuit intégré 10 de sorte que seul subsiste le brin 7c le plus proche de ce circuit et l'élément de soudure vient se fixer à ce brin 7c lors du chauffage dans le four.

La figure 8 illustre schématiquement la possibilité de réaliser une boucle de microfil 7 de façon que ses extrémités 7a et 7b se trouvent non pas sur un même plot mais sur deux plots adjacents 5 et 5a.

Sur les figures 9 et 10, on a représenté une variante de réalisation du procédé d'assemblage objet de l'invention.

Dans cette variante, le substrat d'interconnexion 1 équipé de ses lignes d'interconnexion (non représentées) et de ses plots de contact 5 est destiné à être connecté à des puces de circuit intégré 17 équipées de plots de contact 13.

Les plots de contact 5 du substrat 1 sont recouverts d'éléments de soudure en forme de galettes 15a et les plots de contact 13 des puces de circuit intégré 17 sont équipés de boucle de microfils 7.

La figure 9 représente l'assemblage avant fusion des éléments de soudure et la figure 10 représente l'assemblage après fusion des éléments de soudure, ces derniers ayant alors la forme de sphéroïdes 15b.

Les boucles de microfils 7 de chaque puce sont disposées au voisinage du bord inférieur 14 de la puce correspondante (bord qui vient au contact du substrat 1), de façon à être suffisamment près des galettes de soudure pour pouvoir s'y fixer lors de la fusion de celles-ci.

On précise que, pour réaliser les boucles de microfils 7, les puces à connecter sont amenées sur une machine de soudure par fil du type "wire-bonding" en utilisant des techniques telles que "ball-bonding" ou "wedge-bonding".

Chacun des plots 13 destinés à être connectés est alors muni individuellements d'une boucle de microfil 7.

Cette boucle de microfil est réalisée en amenant le microfil sur le plot, en réalisant une soudure du microfil sur ce plot, en formant la boucle de microfil et en soudant à nouveau celui-ci sur le plot (ou éventuellement un plot proche).

Bien entendu, on coupe le microfil de part et d'autre des deux soudures réalisées afin d'isoler électriquement la boucle formée des autres boucles qui sont déjà formées ou qui seront ensuite formées (les deux soudures correspondant respectivement aux deux extrémités de la boucle formée).

On forme ainsi des boucles de façon simple et fiable.

Une boucle mal réalisée peut être refaite par arrachage de la boucle à l'aide d'un crochet (technique qui est parfaitement connue) et reprise de l'opération de formation de la boucle.

Si cela s' avère nécessaire, l'assemblage obtenu peut être rigidifié par un enrobage tel que celui qui est classiquement réalisé pour la mise en boîtier de circuits électroniques.

Cet enrobage peut être constitué d'un matériau électriquement isolant par exemple en colle époxy 18 déposée aux pieds des puces assemblées sur le substrat 1, de façon à recouvrir les plots 13, les boucles de microfils 7 et les éléments de soudure 15b.

Il est même possible de disposer cet enrobage de façon à ce qu'il recouvre toute la partie en regard de deux puces successives.

La présente invention présente divers avantages :
- dans la configuration où les puces à assembler sont verticales, chaque puce à assembler peut être traitée individuellement pour y former des boucles de microfils, aucune technique microélectronique collective n'étant à appliquer à ces puces pour réaliser ces microfils, d'où un coût de mise en oeuvre extrêmement réduit,
- chaque boucle de microfil mal réalisée peut être refaite individuellement,
- l'utilisation de boucles de microfils, qui ont deux points d'ancrage et dont la longueur peut être très grande, conduit à un assemblage de grande fiabilité.

Bien entendu, l'invention permet de réaliser des interconnexions à l'aide de boucles de microfil entre les deux faces d'une même tranche de silicium et d'autres tranches de silicium.

## Revendications

1. Procédé d'assemblage d'au moins un premier composant électronique (1, 17), muni sur une de ses faces (1a, 17a) d'au moins un premier plot de contact électrique, et d'au moins un second composant électronique (10, 10a, 10b, 10c, 1) muni sur une de ses faces (12, la) d'au moins un second plot (13, 5) de contact électrique destiné à être connecté au premier plot de contact, caractérisé en ce qu'il comprend les étapes suivantes :
a) - réalisation d'une boucle de microfil (7) conducteur ayant au moins une extrémité sur le premier plot de contact et étant orientée perpendiculairement à ladite face du premier composant ;
b) - réalisation d'un élément de soudure (15a) sur le second plot de contact, cet élément étant constitué d'un matériau conducteur dont le point de fusion est inférieur à ceux des premier et second plots et à celui de la boucle de microfil, ce matériau étant apte à mouiller le second plot et la boucle de microfil ;
c) - positionnement des premier et second composants électroniques perpendiculairement entre eux et au contact l'un de l'autre par la tranche, de façon que la boucle de microfil (7) soit en regard de l'élément de soudure (18a) ;
d) - chauffage de l'ensemble pour fondre l'élément de soudure (15b) et assurer la fixation de la boucle de microfil sur l'élément de soudure,
e) - refroidissement de l'ensemble à une température inférieure à la température de fusion de l'élément de soudure.

2. Procédé selon la revendication 1, caractérisé en ce que l'étape a) est réalisée par soudure du microfil conducteur sur le premier plot de contact.

3. Procédé selon l'une quelconque des revendications 1 et 2, caractérisé en ce que la boucle de microfil conducteur est réalisée de façon que ses deux extrémités (7a, 7b) soient sur le premier plot de contact électrique.

4. Procédé selon l'une quelconque des revendications 1 et 2, caractérisé en ce que le premier composant électronique comprend au moins deux premiers plots de contact électrique et en ce que la boucle de microfil conducteur est réalisée de façon que ses deux extrémités (7a, 7b) soient respectivement sur ces deux premiers plots de contact électrique.

5. Procédé selon l'une quelconque des revendications 1 à 4, caractérisé en ce que l'on coupe un brin de la boucle (7) une fois celle-ci réalisée.

6. Procédé selon l'une quelconque des revendications 1 à 5, caractérisé en ce que le centre du ou des seconds plots conducteurs (13) est situé à une distance d d'un bord (14) de ladite face du second composant électronique (10) telle que d<L+((φ/2), avec L représentant la hauteur de la boucle de microfil et φ représentant le diamètre de l'élément de soudure après fusion puis refroidissement de celui-ci.

7. Procédé selon l'une quelconque des revendications 1 à 6, caractérisé en ce que l'étape b) consiste à former sur le second plot une galette (15a) plate en matériau de soudure conducteur dont la surface est supérieure à celle du second plot.

8. Procédé selon l'une quelconque des revendications 1 à 7, caractérisé en ce que chaque microfil a un diamètre allant de 15 à 50µm et en ce que chaque boucle de microfil a une hauteur de 30 à 200µm.

9. Circuit intégré comportant sur une de ses faces (1a) plusieurs premiers plots (5) de contact électrique et destiné à être assemblé par le procédé selon l'une quelconque des revendications 1 à 8, caractérisé en ce que les premiers plots de contact comportent chacun une boucle de microfil conducteur (7) orientée perpendiculairement à ladite face.

10. Circuit intégré comportant sur une de ses faces (12) plusieurs seconds plots (13) de contact électrique et destiné à être assemblé par le procédé selon l'une quelconque des revendications 1 à 8, caractérisé en ce que les seconds plots de contact comportent chacun une galette de soudure (15a) dont le point de fusion est inférieur à celui des seconds plots, la galette ayant une surface supérieure à celle de chaque second plot.
